# EUROPEAN PATENT SPECIFICATION

(11) **EP 3 961 183 B1**
(45) Date of publication and mention of the grant of the patent: **03.09.2025**
(21) Application number: 20934882.0
(22) Date of filing: 31.07.2020
(51) Int. Cl.: G01M 17/08, G06F 30/27, G01M 17/007

(54) **IMPACT SPEED CONTROL METHOD AND APPARATUS, STORAGE MEDIUM AND ELECTRONIC DEVICE**
AUFPRALLGESCHWINDIGKEITSSTEUERUNGSVERFAHREN UND -VORRICHTUNG, SPEICHERMEDIUM UND ELEKTRONISCHE VORRICHTUNG
PROCÉDÉ ET APPAREIL DE CONTRÔLE DE VITESSE D'IMPACT, SUPPORT DE STOCKAGE ET DISPOSITIF ÉLECTRONIQUE

(30) Priority: 29.06.2020 CN 202010607286
(43) Date of publication of application: 02.03.2022
(73) Proprietor: CRRC Changchun Railway Vehicles Co., Ltd., Changchun, Jilin 130000 (CN)
(72) Inventor: LIU, Changqing, Changchun, Jilin 130000 (CN); LI, Benhuai, Changchun, Jilin 130000 (CN); WANG, Lu, Changchun, Jilin 130000 (CN); CHENG, Yajun, Changchun, Jilin 130000 (CN)
(74) Representative: Herrmann, Uwe
(86) International application number: PCT/CN2020/106061
(87) International publication number: WO 2022/000678

(56) References cited:
- CN-A- 106 877 746
- CN-A- 109 118 787
- CN-A- 109 532 831
- CN-A- 110 308 001
- CN-A- 110 758 413
- CN-A- 110 758 413
- JP-A- 2006 153 610
- JP-A- 2018 155 541

## Description

The present application claims priority to Chinese Patent Application No. 202010607286.5, titled "METHOD AND DEVICE FOR CONTROLLING COLLISION VELOCITY, STORAGE MEDIUM AND ELECTRONIC DEVICE", filed on June 29, 2020 with the China National Intellectual Property Administration.

### FIELD

The present disclosure relates to the technical field of data processing, and in particular, to a method and device for controlling a collision velocity, a storage medium and an electronic device.

### BACKGROUND

Personal safety of passengers is under threat once a rail vehicle collision accident occurs. To reduce the loss caused by the rail vehicle collision accident, it is usually necessary to carry out a collision test on the rail vehicle to test the crashworthiness of various parts of the rail vehicle, so as to improve the rail vehicle and reduce the loss of the rail vehicle collision accident.

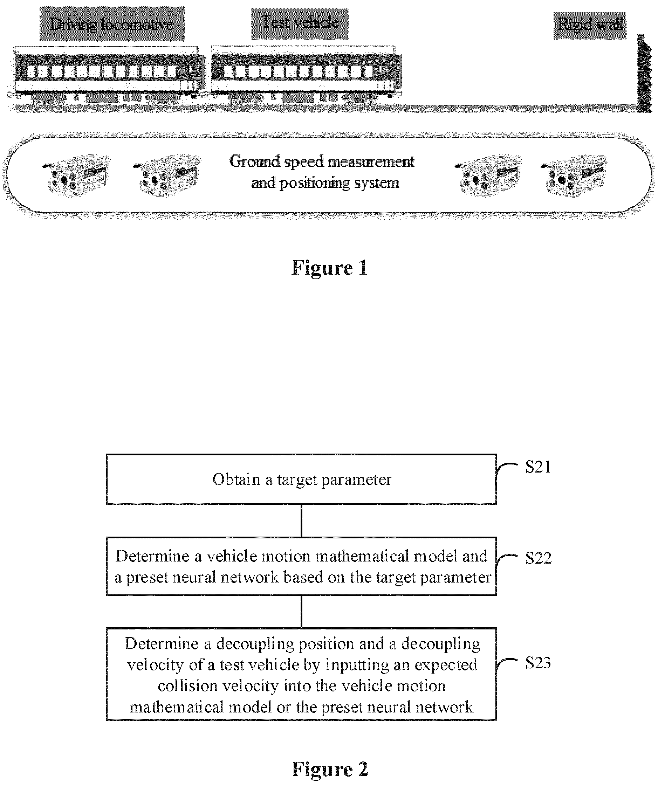

At present, in a rail vehicle collision test in which locomotive traction is used, as shown in Figure 1, a driving locomotive and a test vehicle are connected together by a coupler and draft gear, and move forward together. When the driving locomotive and the test vehicle reach a certain speed, the driving locomotive is separated from the test vehicle, and the test vehicle makes a free deceleration motion without traction. A speed and a position of the test vehicle when the driving locomotive is decoupled from the test vehicle are controlled by an operator, which may threaten personal safety of the operator. Moreover, the free deceleration motion of the test vehicle is an uncontrollable idle running process, and a collision velocity of the test vehicle cannot be accurately controlled.

Therefore, it is a major technical problem to be solved urgently by those skilled in the art to provide a method for controlling a collision velocity, to improve the accuracy of controlling the collision velocity.

CN110758413A discloses a train speed self-adaptive control method based on system parameter identification, and belongs to the field of electric automobiles. The train speed self-adaptive control method comprises the steps that firstly, according to mechanical analysis of a train and torque analysis of a motor, a dynamical model of the train including undetermined parameters is established; then a plurality of groups of practical input and output data are collected to be used as fitting data of a least square method; and the parameters b and c to be distinguished corresponding to the minimum fitting deviation of the least square method are the undetermined parameters, and the complete dynamical model is obtained; and finally, according to the train running in real time and an established train travelling curve, the parameters in the dynamical model are adjusted through a neural network, the train speed is controlled in real time, and train speed self-adaptive control is realized.

CN110308001A discloses an intelligent driving method for a line collision test drive vehicle. A test drive vehicle is connected with a to-be-tested vehicle by using a first vehicle coupler, a close-coupled coupler is used for the first vehicle coupler, and the test drive vehicle is used as a track tractor to drive the to-be-tested vehicle to run; during the test, a ground beacon arranged on the sleeper is identified by a first in-vehicle network control system arranged on the test drive vehicle through a beacon reading device, so that the current position of the test drive vehicle can be determined, and signals are transmitted through a vehicle wireless reconnection unit to a ground console of a ground control room; and a ground network control system arranged on the ground console transmits a traction, braking or decoupling operation instruction to the test drive vehicle through the ground wireless reconnection unit to remotely control the test drive vehicle to perform a collision test.

### SUMMARY

In view of the above, aspects of the invention provide a method and a device for controlling a collision velocity, a storage medium and an electronic device as defined in independent claims 1, 3, 5 and 6. Preferred embodiments are defined in the dependent claims.

To achieve the above objective, following technical solutions are provided according to embodiments of the present invention.

A computer implemented method for controlling a collision velocity includes: obtaining a target parameter, where the target parameter includes an environmental parameter and test data corresponding to different environmental conditions; determining a vehicle motion mathematical model and a preset neural network based on the target parameter; and determining a decoupling position and a decoupling velocity of a test vehicle by inputting an expected collision velocity into the vehicle motion mathematical model or the preset neural network.

According to the claimed invention, the environmental parameter includes a wind speed, a wind direction, a velocity of a test vehicle, a weight of the test vehicle, a counterweight, a rail moisture level, and a rail cleanliness. Determining the vehicle motion mathematical model based on the target parameter includes: creating a wind resistance model based on the wind speed, the wind direction, and the velocity of the test vehicle, where an air resistance is outputted by the wind resistance model; creating a wheel-rail adhesion model based on the weight of the test vehicle, the counterweight, the rail moisture level, and the rail cleanliness, where a wheel-rail adhesive resistance is outputted by the wheel-rail adhesion model; creating a single-vehicle motion control model and a grouped-vehicle motion control module based on the air resistance, the wheel-rail adhesive resistance, and a tractive force, where a target velocity and a target acceleration of a single-vehicle are outputted by the single-vehicle motion control model, and a target velocity and a target acceleration of a grouped-vehicle are outputted by the grouped-vehicle motion control model; and determining the wind resistance model, the wheel-rail adhesion model, the single-vehicle motion control model, and the grouped-vehicle motion control module as the vehicle motion mathematical model.

Optionally, the computer implemented method for controlling a collision velocity further includes: obtaining an actual acceleration of the test vehicle; and correcting the single-vehicle motion control model and the grouped-vehicle motion control model based on the actual acceleration, the target acceleration of a single-vehicle, and the target acceleration of a grouped-vehicle.

According to the claimed invention, the test data corresponding to different environmental conditions includes a real-time position, a velocity, an acceleration, a collision velocity, and a collision stress of both a driving locomotive and a test vehicle. Determining the preset neural network based on the target parameter includes: training the preset neural network based on the real-time position, the velocity, the acceleration, the collision velocity, and the collision stress of the test vehicle; and testing the preset neural network based on the real-time position, the velocity, the acceleration, the collision velocity, and the collision stress of both the driving locomotive and the test vehicle.

A device for controlling a collision velocity includes: a first obtaining module, configured to obtain a target parameter, where the target parameter includes an environmental parameter and test data corresponding to different environmental conditions; a first determination module, configured to determine a vehicle motion mathematical model and a preset neural network based on the target parameter; and a second determination module, configured to determine a decoupling position and a decoupling velocity of a test vehicle by inputting an expected collision velocity into the vehicle motion mathematical model or the preset neural network.

According to the claimed invention, the environmental parameter includes a wind speed, a wind direction, a velocity of a test vehicle, a weight of the test vehicle, a counterweight, a rail moisture level, and a rail cleanliness. The first determination module includes: a first creating unit, configured to create a wind resistance model based on the wind speed, the wind direction, and the velocity of the test vehicle, where an air resistance is outputted by the wind resistance model; a second creating unit, configured to create a wheel-rail adhesion model based on the weight of the test vehicle, the counterweight, the rail moisture level, and the rail cleanliness, where a wheel-rail adhesive resistance is outputted by the wheel-rail adhesion model; a third creating unit, configured to create a single-vehicle motion control model and a grouped-vehicle motion control module based on the air resistance, the wheel-rail adhesive resistance, and a tractive force, where a target velocity and a target acceleration of a single-vehicle are outputted by the single-vehicle motion control model, and a target velocity and a target acceleration of a grouped-vehicle are outputted by the grouped-vehicle motion control model; and a determination unit, configured to determine the wind resistance model, the wheel-rail adhesion model, the single-vehicle motion control model, and the grouped-vehicle motion control module as the vehicle motion mathematical model.

Optionally, the device for controlling a collision velocity further includes: a second obtaining module, configured to obtain an actual acceleration of the test vehicle; and a correction module, configured to correct the single-vehicle motion control model and the grouped-vehicle motion control model based on the actual acceleration, the target acceleration of a single-vehicle, and the target acceleration of a grouped-vehicle.

According to the claimed invention, the test data corresponding to different environmental conditions includes a real-time position, a velocity, an acceleration, a collision velocity, and a collision stress of both a driving locomotive and a test vehicle. The first determination module further includes: a training unit, configured to train the preset neural network based on the real-time position, the velocity, the acceleration, the collision velocity, and the collision stress of the test vehicle; and a test unit, configured to test the preset neural network based on the real-time position, the velocity, the acceleration, the collision velocity, and the collision stress of both the driving locomotive and the test vehicle.

A computer readable storage medium includes a program. The program, when executed, controls a device where the computer readable storage medium is located to perform the computer implemented method for controlling a collision velocity described above.

An electronic device includes at least one processor, at least one memory connected to the processor, and a bus. The processor and the memory communicate with each other through the bus, and the processor is configured to call a program instruction stored in the memory to perform the computer implemented method for controlling a collision velocity described above.

A computer implemented method for controlling a collision velocity is provided according to embodiments of the present invention. In the method, a target parameter is obtained, where the target parameter includes an environmental parameter and test data corresponding to different environmental conditions. A vehicle motion mathematical model and a preset neural network are determined based on the target parameter. Then an expected collision velocity is inputted into the vehicle motion mathematical model or the preset neural network, to determine a decoupling position and a decoupling velocity of a test vehicle. In the method for controlling a collision velocity provided by the embodiments of the present disclosure, the vehicle motion mathematical model and the preset neural network are created and used to predict the decoupling position and decoupling velocity of the test vehicle corresponding to the expected collision velocity, therefore improving the accuracy of controlling the collision velocity.

### BRIEF DESCRIPTION OF THE DRAWINGS

In order to more clearly illustrate technical solutions in embodiments of the present invention or in the conventional technology, drawings used in the description of the embodiments or the conventional technology are introduced briefly hereinafter. Apparently, the drawings described in the following illustrate some embodiments of the present disclosure; other drawings may be obtained by those ordinarily skilled in the art based on these drawings without any creative efforts.
Figure 1 is a schematic diagram of a system for a rail vehicle collision test in which locomotive traction is used according to an embodiment of the present invention;
Figure 2 is a schematic flow chart of a method for controlling a collision velocity according to an embodiment of the present invention;
Figure 3 is a flow block diagram of a method for controlling a collision velocity according to an embodiment of the present invention;
Figure 4 is a flow block diagram of a method for controlling a collision velocity according to another embodiment of the present invention;
Figure 5 is an application architecture diagram of a method for controlling a collision velocity according to an embodiment of the present invention;
Figure 6 is a schematic flow chart of a method for controlling a collision velocity according to another embodiment of the present invention;
Figure 7 is a schematic flow chart of a method for controlling a collision velocity according to another embodiment of the present invention;
Figure 8 is a schematic flow chart of a method for controlling a collision velocity according to another embodiment of the present invention;
Figure 9 is a schematic structural diagram of a device for controlling a collision velocity according to an embodiment of the present invention; and
Figure 10 is a hardware structural diagram of a device for controlling a collision velocity according to an embodiment of the present invention.

### DETAILED DESCRIPTION

Referring to Figure 2, a method for controlling a collision velocity is provided according to an embodiment of the present disclosure, and the method includes following steps S21 to S23.

In step S21, obtain a target parameter.

The target parameter includes an environmental parameter and test data corresponding to different environmental conditions.

In step S22, determine a vehicle motion mathematical model and a preset neural network based on the target parameter.

In step S23, determine a decoupling position and a decoupling velocity of a test vehicle by inputting an expected collision velocity into the vehicle motion mathematical model or the preset neural network.

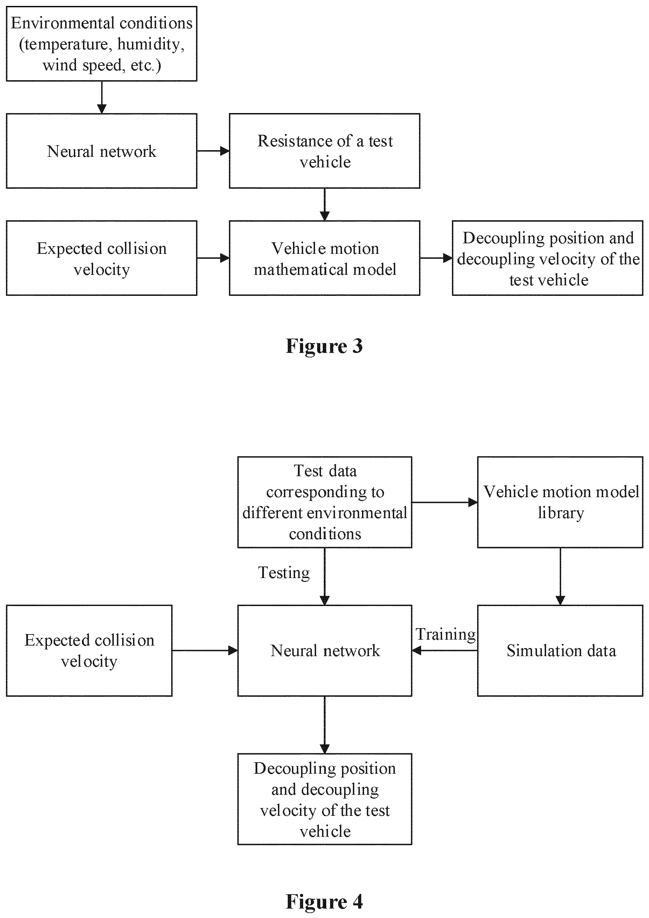

In this embodiment, a data-based vehicle collision test model and a data-physics-based vehicle collision test hybrid model are established based on a data-driven modeling method, to determine a reasonable decoupling position and decoupling velocity in a collision test, as shown in Figure 3. Then, artificial intelligence and machine learning algorithms are applied to explore internal connections among multiple time-varying factors, non-time-varying factors, the decoupling position and the decoupling velocity. After that, data driven and physic models are organically combined, to realize real-time adaptive control of decoupling the vehicle from the locomotive, as shown in Figure 4.

The inventor considers that a single-vehicle, a grouped-vehicle, train weight, resistance and environmental factors will all have an impact on an idle running process of a test vehicle. Thus idle running tests for different single-vehicles, different grouped-vehicles, vehicles with different weights, and different environments are designed. Since it is difficult to realize a physical collision test in a certain environment (environment parameters include temperature, wheel-rail humidity, atmospheric pressure or the like), the reproducibility of the physical collision test is poor, and the consumption of test materials and manpower is large, the software simulation Railsim is utilized, to minimize the defects of the physical collision test and obtain enough test data in a reduced number of physical tests.

When comprehensively analyzing detection data of the collision tests, relevant data is collected according to determined data analysis contents. Specifically, first-hand data is detected by means such as a track inspection vehicle, a portable add-on device and a static detection device, and then second-hand data is obtained by performing data processing on the first-hand data. The data processing includes methods such as elimination of interference values, mileage correction and detection data synchronization.

Based on the theory of multi-body system dynamics and collision mechanics, the longitudinal and three-dimensional collision dynamics theories are used to study the idle running process of the single-vehicle, the idle running process of the grouped-vehicle, and further to create a wind resistance model and a wheel-rail adhesion model. Thus various laws of the idle running process of vehicles and dynamic response of a structure of the vehicles are mastered.

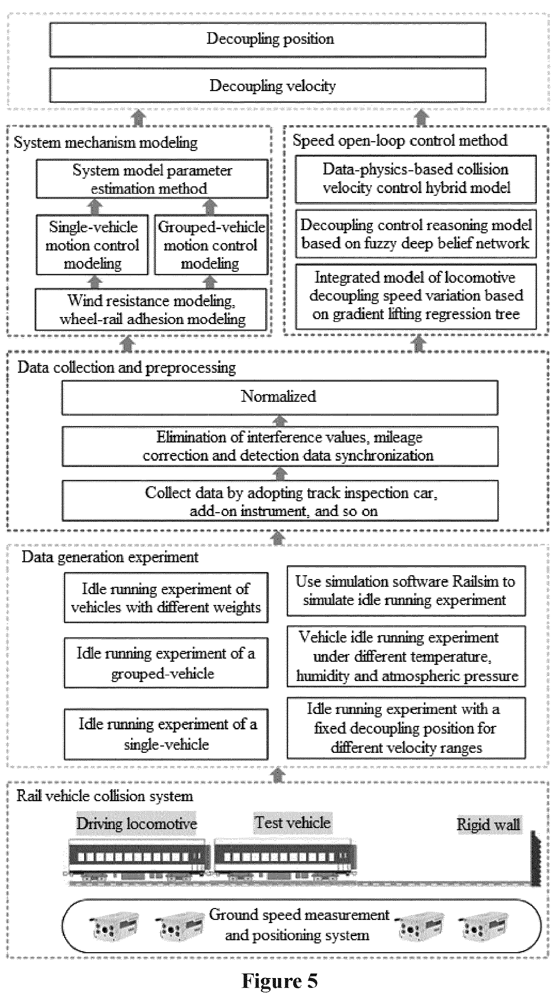

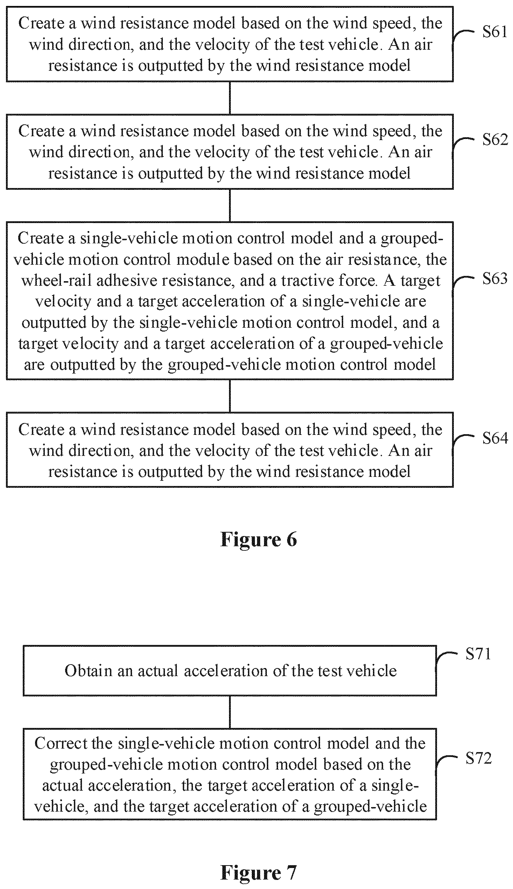

Based on the above embodiment and combined with the architecture of Figure 5, a specific implementation method for determining a vehicle motion mathematical model based on the target parameter is provided according to an embodiment of the present invention. The environmental parameter includes a wind speed, a wind direction, a velocity of a test vehicle, a weight of the test vehicle, a counterweight, a rail moisture level, and a rail cleanliness. As shown in Figure 6, determining the vehicle motion mathematical model based on the target parameter includes steps S61 to S64.

In step S61, create a wind resistance model based on the wind speed, the wind direction, and the velocity of the test vehicle. An air resistance is outputted by the wind resistance model.

In step S62, create a wheel-rail adhesion model based on the weight of the test vehicle, the counterweight, the rail moisture level, and the rail cleanliness. A wheel-rail adhesive resistance is outputted by the wheel-rail adhesion model.

In step S63, create a single-vehicle motion control model and a grouped-vehicle motion control module based on the air resistance, the wheel-rail adhesive resistance, and a tractive force. A target velocity and a target acceleration of a single-vehicle are outputted by the single-vehicle motion control model, and a target velocity and a target acceleration of a grouped-vehicle are outputted by the grouped-vehicle motion control model.

In step S64, determine the wind resistance model, the wheel-rail adhesion model, the single-vehicle motion control model, and the grouped-vehicle motion control module as the vehicle motion mathematical model.

Based on the above embodiment, referring to Figure 7, the method for controlling a collision velocity according to an embodiment of the present invention may further include following steps S71 and S72.

In step S71, obtain an actual acceleration of the test vehicle.

In step S72, correct the single-vehicle motion control model and the grouped-vehicle motion control model based on the actual acceleration, the target acceleration of a single-vehicle, and the target acceleration of a grouped-vehicle.

That is, after the single-vehicle motion control model and the grouped-vehicle motion control model are created, the single-vehicle motion control model and the grouped-vehicle motion control model are further corrected in the embodiment of the present invention.

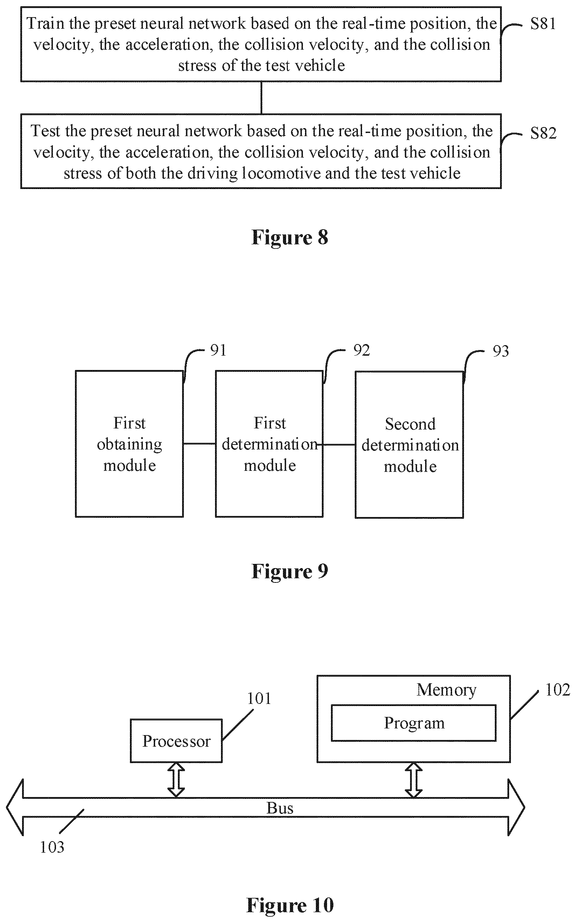

Referring to Figure 8, a specific implementation method for determining a preset neural network based on the target parameter is provided according to an embodiment of the present invention. The test data corresponding to different environmental conditions includes a real-time position, a velocity, an acceleration, a collision velocity, and a collision stress of both a driving locomotive and a test vehicle. Determine the preset neural network based on the target parameter includes following steps S81 to S82.

In step S81, train the preset neural network based on the real-time position, the velocity, the acceleration, the collision velocity, and the collision stress of the test vehicle.

In step S82, test the preset neural network based on the real-time position, the velocity, the acceleration, the collision velocity, and the collision stress of both the driving locomotive and the test vehicle.

For example, the test data may be divided into three parts, two of which are used for testing the preset neural network, and one of which is used for training the preset neural network. It should be noted that, in this embodiment, data used for training the neural network may be obtained by deleting data related to the driving locomotive from a vehicle motion model library.

Based on the above embodiment, referring to Figure 9, a device for controlling a collision velocity is provided according to an embodiment of the present invention. The device includes a first obtaining module 91, a first determination module 92 and a second determination module 93.

The first obtaining module 91 is configured to obtain a target parameter, where the target parameter includes an environmental parameter and test data corresponding to different environmental conditions.

The first determination module 92 is configured to determine a vehicle motion mathematical model and a preset neural network based on the target parameter.

The second determination module 93 is configured to determine a decoupling position and a decoupling velocity of a test vehicle by inputting an expected collision velocity into the vehicle motion mathematical model or the preset neural network.

The environmental parameter includes a wind speed, a wind direction, a velocity of a test vehicle, a weight of the test vehicle, a counterweight, a rail moisture level, and a rail cleanliness. The first determination module includes a first creating unit, a second creating unit, a third creating unit and a determination unit.

The first creating unit is configured to create a wind resistance model based on the wind speed, the wind direction, and the velocity of the test vehicle. An air resistance is outputted by the wind resistance model.

The second creating unit is configured to create a wheel-rail adhesion model based on the weight of the test vehicle, the counterweight, the rail moisture level, and the rail cleanliness. A wheel-rail adhesive resistance is outputted by the wheel-rail adhesion model.

The third creating unit is configured to create a single-vehicle motion control model and a grouped-vehicle motion control module based on the air resistance, the wheel-rail adhesive resistance, and a tractive force. A target velocity and a target acceleration of a single-vehicle are outputted by the single-vehicle motion control model, and a target velocity and a target acceleration of a grouped-vehicle are outputted by the grouped-vehicle motion control model.

The determination unit is configured to determine the wind resistance model, the wheel-rail adhesion model, the single-vehicle motion control model, and the grouped-vehicle motion control module as the vehicle motion mathematical model.

The device for controlling a collision velocity according to an embodiment of the disclosure further includes a second obtaining module and a correction module.

The second obtaining module is configured to obtain an actual acceleration of the test vehicle.

The correction module is configured to correct the single-vehicle motion control model and the grouped-vehicle motion control model based on the actual acceleration, the target acceleration of a single-vehicle, and the target acceleration of a grouped-vehicle.

The test data corresponding to different environmental conditions includes a real-time position, a velocity, an acceleration, a collision velocity, and a collision stress of both a driving locomotive and a test vehicle. The first determination module further includes a training unit and a test unit.

The training unit is configured to train the preset neural network based on the real-time position, the velocity, the acceleration, the collision velocity, and the collision stress of the test vehicle.

The test unit is configured to test the preset neural network based on the real-time position, the velocity, the acceleration, the collision velocity, and the collision stress of both the driving locomotive and the test vehicle.

The working principle of the device for controlling a collision velocity in this embodiment may refer to that in the above method embodiment, which will not be described again herein.

The device for controlling a collision velocity includes a processor and a memory. The first obtaining module, the first determination module, and the second determination module are all stored in the memory as program units, and the program units stored in the memory are executed by the processor to realize corresponding functions.

The processor includes a kernel, and the kernel is configured to call a corresponding program unit in the memory. One or more kernels may be set, and the accuracy of controlling the collision velocity may be improved by adjusting a parameter of the kernel.

A computer readable storage medium is provided according to an embodiment of the present disclosure, and the computer readable storage medium is stored with a program. The program, when executed by a processor, causes the processor to perform the aforementioned method for controlling a collision velocity.

A processor is provided according to an embodiment of the present invention, and the processor is configured to execute a program. The program, when executed by the processor, causes the process to perform the aforementioned method for controlling a collision velocity.

An electronic device is provided according to an embodiment of the present invention, as shown in Figure 10, the electronic device includes: at least one processor 101, at least one memory 102 connected to the processor, and a bus 103. The processor and the memory communicate with each other through the bus, and the processor is configured to call a program instruction stored in the memory to perform the aforementioned method for controlling a collision velocity. The electronic device may be a server, a PC, a PAD, a mobile phone, etc.

A computer program product is provided according to an embodiment of the present invention The computer program product, when executed by a data processing device, executes a program that is initialized with following method steps:
obtaining a target parameter, where the target parameter includes an environmental parameter and test data corresponding to different environmental conditions;
determining a vehicle motion mathematical model and a preset neural network based on the target parameter; and
determining a decoupling position and a decoupling velocity of a test vehicle by inputting an expected collision velocity into the vehicle motion mathematical model or the preset neural network.

The the environmental parameter includes a wind speed, a wind direction, a velocity of a test vehicle, a weight of the test vehicle, a counterweight, a rail moisture level, and a rail cleanliness, determining the vehicle motion mathematical model based on the target parameter includes:
creating a wind resistance model based on the wind speed, the wind direction, and the velocity of the test vehicle, where an air resistance is outputted by the wind resistance model;
creating a wheel-rail adhesion model based on the weight of the test vehicle, the counterweight, the rail moisture level, and the rail cleanliness, where a wheel-rail adhesive resistance is outputted by the wheel-rail adhesion model;
creating a single-vehicle motion control model and a grouped-vehicle motion control module based on the air resistance, the wheel-rail adhesive resistance, and a tractive force, where a target velocity and a target acceleration of a single-vehicle are outputted by the single-vehicle motion control model, and a target velocity and a target acceleration of a grouped-vehicle are outputted by the grouped-vehicle motion control model; and
determining the wind resistance model, the wheel-rail adhesion model, the single-vehicle motion control model, and the grouped-vehicle motion control module as the vehicle motion mathematical model.

Optionally, the program executed by the computer program product further includes:
obtaining an actual acceleration of the test vehicle; and
correcting the single-vehicle motion control model and the grouped-vehicle motion control model based on the actual acceleration, the target acceleration of a single-vehicle, and the target acceleration of a grouped-vehicle.

The the test data corresponding to different environmental conditions includes a real-time position, a velocity, an acceleration, a collision velocity, and a collision stress of both a driving locomotive and a test vehicle, determining the preset neural network based on the target parameter includes:
training the preset neural network based on the real-time position, the velocity, the acceleration, the collision velocity, and the collision stress of the test vehicle; and
testing the preset neural network based on the real-time position, the velocity, the acceleration, the collision velocity, and the collision stress of both the driving locomotive and the test vehicle.

In summary, a method and device for controlling a collision velocity, a storage medium and an electronic device are provided according the present invention. In the method, a target parameter is obtained, where the target parameter includes an environmental parameter and test data corresponding to different environmental conditions. A vehicle motion mathematical model and a preset neural network are determined based on the target parameter. Then an expected collision velocity is inputted into the vehicle motion mathematical model or the preset neural network, to determine a decoupling position and a decoupling velocity of a test vehicle. In the method for controlling a collision velocity provided by the embodiments of the present disclosure, the vehicle motion mathematical model and the preset neural network are created and used to predict the decoupling position and decoupling velocity of the test vehicle corresponding to the expected collision velocity, therefore improving the accuracy of controlling the collision velocity.

The present invention is described with reference to flowcharts and/or block diagrams of the methods, devices (systems) and computer program products according to the embodiments. It should be understood that, each flow or a combination of flows in the flowcharts and/or each block or a combination of blocks in the block diagrams may be implemented by computer program instructions. The computer program instructions may be provided to a general-purpose computer, a dedicated computer, an embedded processor or processors of other programmable data processing devices to generate a machine, so that the instructions executed by the computer or the processors of the other programmable data processing devices generate a device for implementing functions specified in one or more flows of the flowcharts and/or one or more blocks of the block diagrams.

In a typical configuration, the device includes one or more processors (CPUs), memory, and buses. The device may also include input/output interfaces, network interfaces, and so on.

The memory may be implemented by computer readable medium of a non-persistent memory, a random-access memory (RAM), and/or a non-volatile memory, such as a read only memory (ROM) or a flash RAM. The memory includes at least one memory chip. The memory is an example of the computer-readable medium.

The computer readable medium may include a persistent and non-persistent, and removable and non-removable medium. Information may be stored by any methods or technologies. The information may be computer readable instructions, data structures, program modules or other data. The storage medium of the computer may include but is not limited to a phase change random-access memory (PRAM), a static random-access memory (SRAM), a dynamic random-access memory (DRAM), other types of random-access memory (RAM), read-only memory (ROM), electrically erasable programmable read-only memory (EEPROM), flash memory or other memory, compact disk read-only memory (CD-ROM), digital Versatile disc (DVD), or other optical storage, cassette tape, tape disk memory or other magnetic storage, or any non-transmission medium which can be used to store information accessible by the computer. As defined in the present disclosure, the computer readable medium does not include transitory computer-readable media, such as a modulated data signal and carrier wave.

It should be noted that, terms "include", "comprise" or any other variants are intended to be non-exclusive. Therefore, a process, method, article or device including multiple elements includes not only the elements but also other elements that are not enumerated, or also include the elements inherent for the process, method, article or device. Unless expressively limited, the statement "including a..." does not exclude the case that other similar elements may exist in the process, the method, the article or the device other than enumerated elements.

It should be understood by those skilled in the art that the embodiments of the present invention may be implemented as methods, systems or computer program products. The present disclosure may be implemented as computer program products on one or more computer storage mediums (including but not limited to a magnetic disk memory, CD-ROM and an optical memory or the like) including computer-readable program codes.

The above are merely embodiments of the present invention, and are not to limit the present invention. For those skilled in the art, various modifications and changes may be made to the embodiments of the present invention.

## Claims

1. A computer implemented method for controlling a collision velocity, comprising:
obtaining a target parameter, wherein the target parameter comprises an environmental parameter and test data corresponding to different environmental conditions (S21), wherein the environmental parameter comprises a wind speed, a wind direction, a weight of a test vehicle, a counterweight, a rail moisture level and a rail cleanliness, wherein the test data corresponding to different environmental conditions comprises a real-time position, a velocity, an acceleration, a collision velocity, and a collision stress of both a driving locomotive and the test vehicle;
determining a vehicle motion mathematical model and a preset neural network based on the target parameter (S22); and
determining a decoupling position and a decoupling velocity of the test vehicle by inputting an expected collision velocity into the vehicle motion mathematical model or the preset neural network (S23),
wherein determining the vehicle motion mathematical model based on the target parameter (S22) comprises:
creating a wind resistance model based on the wind speed and the wind direction, wherein an air resistance is outputted by the wind resistance model (S61); creating a wheel-rail adhesion model based on the weight of the test vehicle, the counterweight, the rail moisture level, and the rail cleanliness, wherein a wheel-rail adhesive resistance is outputted by the wheel-rail adhesion model (S62); creating a single-vehicle motion control model and a grouped-vehicle motion control module based on the air resistance, the wheel-rail adhesive resistance, and a tractive force, wherein a target velocity and a target acceleration of a single-vehicle are outputted by the single-vehicle motion control model, and a target velocity and a target acceleration of a grouped-vehicle are outputted by the grouped-vehicle motion control model (S63); and determining the wind resistance model, the wheel-rail adhesion model, the single-vehicle motion control model, and the grouped-vehicle motion control module as the vehicle motion mathematical model (S64),
wherein determining the preset neural network based on the target parameter (S22) comprises: training the preset neural network based on the real-time position, the velocity, the acceleration, the collision velocity, and the collision stress of the test vehicle (S81); and testing the preset neural network based on the real-time position, the velocity, the acceleration, the collision velocity, and the collision stress of both the driving locomotive and the test vehicle (S82).

2. The computer implemented method for controlling a collision velocity according to claim 1, further comprising:
obtaining an actual acceleration of the test vehicle (S71); and
correcting the single-vehicle motion control model and the grouped-vehicle motion control model based on the actual acceleration, the target acceleration of a single-vehicle, and the target acceleration of a grouped-vehicle (S72).

3. A device for controlling a collision velocity, comprising:
a first obtaining module (91), configured to obtain a target parameter, wherein the target parameter comprises an environmental parameter and test data corresponding to different environmental conditions, wherein the environmental parameter comprises a wind speed, a wind direction, a weight of a test vehicle, a counterweight, a rail moisture level, and a rail cleanliness, wherein the test data corresponding to different environmental conditions comprises a real-time position, a velocity, an acceleration, a collision velocity, and a collision stress of both a driving locomotive and the test vehicle;
a first determination module (92), configured to determine a vehicle motion mathematical model and a preset neural network based on the target parameter; and
a second determination module (93), configured to determine a decoupling position and a decoupling velocity of the test vehicle by inputting an expected collision velocity into the vehicle motion mathematical model or the preset neural network,
wherein the first determination module (92) comprises: a first creating unit, configured to create a wind resistance model based on the wind speed and the wind direction, wherein an air resistance is outputted by the wind resistance model; a second creating unit, configured to create a wheel-rail adhesion model based on the weight of the test vehicle, the counterweight, the rail moisture level, and the rail cleanliness, wherein a wheel-rail adhesive resistance is outputted by the wheel-rail adhesion model; a third creating unit, configured to create a single-vehicle motion control model and a grouped-vehicle motion control module based on the air resistance, the wheel-rail adhesive resistance, and a tractive force, wherein a target velocity and a target acceleration of a single-vehicle are outputted by the single-vehicle motion control model, and a target velocity and a target acceleration of a grouped-vehicle are outputted by the grouped-vehicle motion control model; and a determination unit, configured to determine the wind resistance model, the wheel-rail adhesion model, the single-vehicle motion control model, and the grouped-vehicle motion control module as the vehicle motion mathematical model,
wherein the first determination module (92) further comprises: a training unit, configured to train the preset neural network based on the real-time position, the velocity, the acceleration, the collision velocity, and the collision stress of the test vehicle; and a test unit, configured to test the preset neural network based on the real-time position, the velocity, the acceleration, the collision velocity, and the collision stress of both the driving locomotive and the test vehicle.

4. The device for controlling a collision velocity according to claim 3, further comprising:
a second obtaining module, configured to obtain an actual acceleration of the test vehicle; and
a correction module, configured to correct the single-vehicle motion control model and the grouped-vehicle motion control model based on the actual acceleration, the target acceleration of a single-vehicle, and the target acceleration of a grouped-vehicle.

5. A computer readable storage medium comprising a program which, when executed by a computer, cause the computer to carry out the method according to any of claims 1 and 2.

6. An electronic device comprising at least one processor (101), at least one memory (102) connected to the processor (101), and a bus (103); wherein the processor (101) and the memory (102) communicate with each other through the bus, and the processor (101) is configured to call a program instruction stored in the memory (102) to perform the computer implemented method for controlling a collision velocity according to any one of claims 1 to 2.

## Patentansprüche

1. Computerimplementiertes Verfahren zum Steuern einer Kollisionsgeschwindigkeit, umfassend:
Erhalten eines Zielparameters, wobei der Zielparameter einen Umgebungsparameter und Testdaten umfasst, die unterschiedlichen Umgebungsbedingungen (S21) entsprechen, wobei der Umgebungsparameter eine Windstärke, eine Windrichtung, ein Gewicht eines Testfahrzeugs, ein Gegengewicht, einen Schienenfeuchtigkeitsgehalt und eine Schienensauberkeit umfasst, wobei die Testdaten, die unterschiedlichen Umgebungsbedingungen entsprechen, eine Echtzeitposition, eine Geschwindigkeit, eine Beschleunigung, eine Kollisionsgeschwindigkeit und eine Kollisionsbelastung sowohl einer fahrenden Lokomotive als auch des Testfahrzeugs umfassen;
Bestimmen eines mathematischen Fahrzeugbewegungsmodells und eines voreingestellten neuronalen Netzwerks anhand des Zielparameters (S22); und
Bestimmen einer Entkopplungsposition und einer Entkopplungsgeschwindigkeit des Testfahrzeugs durch Eingeben einer erwarteten Kollisionsgeschwindigkeit in das mathematische Fahrzeugbewegungsmodell oder das voreingestellte neuronale Netzwerk (S23),
wobei das Bestimmen des mathematischen Fahrzeugbewegungsmodells anhand des Zielparameters (S22) Folgendes umfasst:
Erzeugen eines Windwiderstandsmodells anhand der Windstärke und der Windrichtung, wobei ein Luftwiderstand durch das Windwiderstandsmodell (S61) ausgegeben wird; Erzeugen eines Rad-Schiene-Haftungsmodells anhand des Gewichts des Testfahrzeugs, des Gegengewichts, des Schienenfeuchtigkeitsgehalts und der Schienensauberkeit, wobei ein Rad-Schiene-Haftungswiderstand durch das Rad-Schiene-Haftungsmodell (S62) ausgegeben wird; Erzeugen eines Einzelfahrzeug-Bewegungssteuermodells und eines Gruppenfahrzeug-Bewegungssteuermoduls anhand des Luftwiderstands, des Rad-Schiene-Haftwiderstands und einer Zugkraft, wobei eine Zielgeschwindigkeit und eine Zielbeschleunigung eines Einzelfahrzeugs durch das Einzelfahrzeug-Bewegungssteuermodell ausgegeben werden und eine Zielgeschwindigkeit und eine Zielbeschleunigung eines Gruppenfahrzeugs durch das Gruppenfahrzeug-Bewegungssteuermodell (S63) ausgegeben werden; und Bestimmen des Windwiderstandsmodells, des Rad-Schiene-Haftungsmodells, des Einzelfahrzeug-Bewegungssteuermodells und des Gruppenfahrzeug-Bewegungssteuermoduls als das mathematische Fahrzeugbewegungsmodell (S64),
wobei das Bestimmen des voreingestellten neuronalen Netzwerks anhand des Zielparameters (S22) Folgendes umfasst: Trainieren des voreingestellten neuronalen Netzwerks anhand der Echtzeitposition, der Geschwindigkeit, der Beschleunigung, der Kollisionsgeschwindigkeit und der Kollisionsbelastung des Testfahrzeugs (S81); und Testen des voreingestellten neuronalen Netzwerks anhand der Echtzeitposition, der Geschwindigkeit, der Beschleunigung, der Kollisionsgeschwindigkeit und der Kollisionsbelastung sowohl der fahrenden Lokomotive als auch des Testfahrzeugs (S82).

2. Computerimplementiertes Verfahren zum Steuern einer Kollisionsgeschwindigkeit nach Anspruch 1, ferner umfassend:
Erhalten einer tatsächlichen Beschleunigung des Testfahrzeugs (S71); und
Korrigieren des Einzelfahrzeug-Bewegungssteuermodells und des Gruppenfahrzeug-Bewegungssteuermodells anhand der tatsächlichen Beschleunigung, der Zielbeschleunigung eines Einzelfahrzeugs und der Zielbeschleunigung eines Gruppenfahrzeugs (S72).

3. Vorrichtung zum Steuern einer Kollisionsgeschwindigkeit, umfassend:
ein erstes Erhaltungsmodul (91), das so konfiguriert ist, dass es einen Zielparameter erhält, wobei der Zielparameter einen Umgebungsparameter und Testdaten umfasst, die unterschiedlichen Umgebungsbedingungen entsprechen, wobei der Umgebungsparameter eine Windstärke, eine Windrichtung, ein Gewicht eines Testfahrzeugs, ein Gegengewicht, einen Schienenfeuchtigkeitsgehalt und eine Schienensauberkeit umfasst, wobei die Testdaten, die unterschiedlichen Umgebungsbedingungen entsprechen, eine Echtzeitposition, eine Geschwindigkeit, eine Beschleunigung, eine Kollisionsgeschwindigkeit und eine Kollisionsbelastung sowohl einer fahrenden Lokomotive als auch des Testfahrzeugs umfassen;
ein erstes Bestimmungsmodul (92), das so konfiguriert ist, dass es ein mathematisches Fahrzeugbewegungsmodell und ein voreingestelltes neuronales Netzwerk anhand des Zielparameters bestimmt; und
ein zweites Bestimmungsmodul (93), das so konfiguriert ist, dass es eine Entkopplungsposition und eine Entkopplungsgeschwindigkeit des Testfahrzeugs durch Eingeben einer erwarteten Kollisionsgeschwindigkeit in das mathematische Fahrzeugbewegungsmodell oder das voreingestellte neuronale Netzwerk (S23) bestimmt,
wobei das erste Bestimmungsmodul (92) Folgendes umfasst: eine erste Erzeugungseinheit, die so konfiguriert ist, dass sie ein Windwiderstandsmodell anhand der Windstärke und der Windrichtung erzeugt, wobei ein Luftwiderstand durch das Windwiderstandsmodell ausgegeben wird; eine zweite Erzeugungseinheit, die so konfiguriert ist, dass sie ein Rad-Schiene-Haftungsmodell anhand des Gewichts des Testfahrzeugs, des Gegengewichts, des Schienenfeuchtigkeitsgehalts und der Schienensauberkeit erzeugt, wobei ein Rad-Schiene-Haftungswiderstand durch das Rad-Schiene-Haftungsmodell ausgegeben wird; eine dritte Erzeugungseinheit, die so konfiguriert ist, dass sie ein Einzelfahrzeug-Bewegungssteuermodell und ein Gruppenfahrzeug-Bewegungssteuermodul anhand des Luftwiderstands, des Rad-Schiene-Haftwiderstands und einer Zugkraft erzeugt, wobei eine Zielgeschwindigkeit und eine Zielbeschleunigung eines Einzelfahrzeugs durch das Einzelfahrzeug-Bewegungssteuermodell ausgegeben werden und eine Zielgeschwindigkeit und eine Zielbeschleunigung eines Gruppenfahrzeugs durch das Gruppenfahrzeug-Bewegungssteuermodell ausgegeben werden; und eine Bestimmungseinheit, die so konfiguriert ist, dass sie das Windwiderstandsmodell, das Rad-Schiene-Haftungsmodell, das Einzelfahrzeug-Bewegungssteuermodell und das Gruppenfahrzeug-Bewegungssteuermodul als das mathematische Fahrzeugbewegungsmodell (S64) bestimmt,
wobei das erste Bestimmungsmodul (92) ferner Folgendes umfasst: eine Trainingseinheit, die so konfiguriert ist, dass sie das voreingestellte neuronale Netzwerk anhand der Echtzeitposition, der Geschwindigkeit, der Beschleunigung, der Kollisionsgeschwindigkeit und der Kollisionsbelastung des Testfahrzeugs trainiert; und eine Testeinheit, die so konfiguriert ist, dass sie das voreingestellte neuronale Netzwerk anhand der Echtzeitposition, der Geschwindigkeit, der Beschleunigung, der Kollisionsgeschwindigkeit und der Kollisionsbelastung sowohl der fahrenden Lokomotive als auch des Testfahrzeugs testet.

4. Vorrichtung zum Steuern einer Kollisionsgeschwindigkeit nach Anspruch 3, die ferner Folgendes umfasst:
ein zweites Erhaltungsmodul, das so konfiguriert ist, dass es eine tatsächliche Beschleunigung des Testfahrzeugs erhält; und
ein Korrekturmodul, das so konfiguriert ist, dass es das Einzelfahrzeug-Bewegungssteuermodell und das Gruppenfahrzeug-Bewegungssteuermodell anhand der tatsächlichen Beschleunigung, der Zielbeschleunigung eines Einzelfahrzeugs und der Zielbeschleunigung eines Gruppenfahrzeugs korrigiert.

5. Computerlesbares Speichermedium, umfassend ein Programm, das, wenn es durch einen Computer ausgeführt wird, den Computer veranlasst, das Verfahren nach einem der Ansprüche 1 und 2 durchzuführen.

6. Elektronische Vorrichtung, umfassend mindestens einen Prozessor (101), mindestens einen Speicher (102), der mit dem Prozessor (101) verbunden ist, und einen Bus (103); wobei der Prozessor (101) und der Speicher (102) über den Bus miteinander in Verbindung stehen und der Prozessor (101) so konfiguriert ist, dass er eine Programmanweisung aufruft, die in dem Speicher (102) gespeichert ist, um das computerimplementierte Verfahren zum Steuern einer Kollisionsgeschwindigkeit nach einem der Ansprüche 1 bis 2 durchzuführen.

## Revendications

1. Procédé mis en œuvre par ordinateur de commande d'une vitesse de collision, comprenant :
l'obtention d'un paramètre cible, dans lequel le paramètre cible comprend un paramètre environnemental et des données de test correspondant à différentes conditions environnementales (E21), dans lequel le paramètre environnemental comprend une vitesse du vent, une direction du vent, un poids d'un véhicule test, un contrepoids, un niveau d'humidité de rail et une propreté de rail, dans lequel les données de test correspondant à différentes conditions environnementales comprennent une position en temps réel, une vitesse, une accélération, une vitesse de collision, et une contrainte de collision à la fois d'une locomotive motrice et du véhicule test ;
la détermination d'un modèle mathématique de mouvement de véhicule et d'un réseau neuronal préétabli sur la base du paramètre cible (E22) ; et
la détermination d'une position de découplage et d'une vitesse de découplage d'un véhicule test en entrant une vitesse de collision attendue dans le modèle mathématique de mouvement de véhicule ou le réseau neuronal préétabli (E23),
dans lequel la détermination du modèle mathématique de mouvement de véhicule sur la base du paramètre cible (E22) comprend :
la création d'un modèle de résistance au vent sur la base de la vitesse du vent et de la direction du vent, dans lequel une résistance à l'air est délivrée en sortie par le modèle de résistance au vent (E61) ; la création d'un modèle d'adhérence roue-rail basé sur le poids du véhicule test, du contrepoids, du niveau d'humidité de rail, et de la propreté de rail, dans lequel une résistance d'adhérence roue-rail est délivrée en sortie par le modèle d'adhérence roue-rail (E62) ; la création d'un modèle de commande de mouvement de véhicule unique et d'un module de commande de mouvement de véhicule groupé sur la base de la résistance à l'air, de la résistance à l'adhérence roue-rail, et d'une force de traction, dans lequel une vitesse cible et une accélération cible d'un véhicule unique sont délivrées en sortie par le modèle de commande de mouvement de véhicule unique, et une vitesse cible et une accélération cible d'un véhicule groupé sont délivrées en sortie par le modèle de commande de mouvement de véhicule groupé (E63) ; et la détermination du modèle de résistance au vent, du modèle d'adhérence roue-rail, du modèle de commande de mouvement de véhicule unique, et du module de commande de mouvement de véhicule groupé comme le modèle mathématique de mouvement de véhicule (E64),
dans lequel la détermination du réseau neuronal préétabli sur la base du paramètre cible (E22) comprend : l'entraînement du réseau neuronal préétabli sur la base de la position en temps réel, de la vitesse, de l'accélération, de la vitesse de collision et de la contrainte de collision du véhicule test (E81) ; et le test du réseau neuronal préétabli sur la base de la position en temps réel, de la vitesse, de l'accélération, de la vitesse de collision et de la contrainte de collision à la fois de la locomotive motrice et du véhicule test (E82).

2. Procédé mis en œuvre par ordinateur de commande d'une vitesse de collision selon la revendication 1, comprenant en outre :
l'obtention d'une accélération réelle du véhicule test (E71) ; et
la correction du modèle de commande de mouvement de véhicule unique et du modèle de commande de mouvement de véhicule groupé sur la base de l'accélération réelle, de l'accélération cible d'un véhicule unique, et de l'accélération cible d'un véhicule groupé (E72).

3. Dispositif de commande d'une vitesse de collision, comprenant :
un premier module d'obtention (91), configuré pour obtenir un paramètre cible, dans lequel le paramètre cible comprend un paramètre environnemental et des données de test correspondant à différentes conditions environnementales,
dans lequel le paramètre environnemental comprend une vitesse du vent, une direction du vent, un poids d'un véhicule test, un contrepoids, un niveau d'humidité de rail, et une propreté de rail, dans lequel les données de test correspondant à différentes conditions environnementales comprennent une position en temps réel, une vitesse, une accélération, une vitesse de collision et une contrainte de collision à la fois d'une locomotive motrice et du véhicule test ;
un premier module de détermination (92) configuré pour déterminer un modèle mathématique de mouvement de véhicule et un réseau neuronal préétabli sur la base du paramètre cible ; et
un deuxième module de détermination (93), configuré pour déterminer une position de découplage et une vitesse de découplage du véhicule test en entrant une vitesse de collision attendue dans le modèle mathématique de mouvement du véhicule ou le réseau neuronal préétabli,
dans lequel le premier module de détermination (92) comprend une première unité de création configurée pour créer un modèle de résistance au vent sur la base de la vitesse du vent et de la direction du vent, dans lequel une résistance à l'air est délivrée en sortie par le modèle de résistance au vent ; une deuxième unité de création, configurée pour créer un modèle d'adhérence roue-rail basé sur le poids du véhicule test, le contrepoids, le niveau d'humidité du rail, et la propreté du rail, dans lequel une résistance d'adhérence roue-rail est délivrée en sortie par le modèle d'adhérence roue-rail ; une troisième unité de création, configurée pour créer un modèle de commande de mouvement de véhicule unique et un module de commande de mouvement de véhicule groupé sur la base de la résistance à l'air, de la résistance d'adhérence roue-rail, et d'une force de traction, dans lequel une vitesse cible et une accélération cible d'un véhicule unique sont délivrées en sortie par le modèle de commande de mouvement de véhicule unique, et une vitesse cible et une accélération cible d'un véhicule groupé sont délivrées en sortie par le modèle de commande de mouvement de véhicule groupé ; et une unité de détermination, configurée pour déterminer le modèle de résistance au vent, le modèle d'adhérence roue-rail, le modèle de commande de mouvement de véhicule unique, et le module de commande de mouvement de véhicule groupé comme modèle mathématique de mouvement de véhicule,
dans lequel le premier module de détermination (92) comprend en outre : une unité d'entraînement configurée pour entraîner le réseau neuronal préétabli sur la base de la position en temps réel, de la vitesse, de l'accélération, de la vitesse de collision et de la contrainte de collision du véhicule test ; et une unité de test, configurée pour tester le réseau neuronal préétabli sur la base de la position en temps réel, de la vitesse, de l'accélération, de la vitesse de collision, et de la contrainte de collision à la fois de la locomotive motrice et du véhicule test.

4. Dispositif de commande d'une vitesse de collision selon la revendication 3, comprenant en outre :
un deuxième module d'obtention, configuré pour obtenir une accélération réelle du véhicule test ; et
un module de correction, configuré pour corriger le modèle de commande de mouvement de véhicule unique et le modèle de commande de mouvement de véhicule groupé sur la base de l'accélération réelle, de l'accélération cible d'un véhicule unique, et de l'accélération cible d'un véhicule groupé.

5. Support de stockage lisible par ordinateur comprenant un programme qui, lorsqu'il est exécuté par un ordinateur, amène l'ordinateur à réaliser le procédé selon l'une quelconque des revendications 1 et 2.

6. Dispositif électronique comprenant au moins un processeur (101), au moins une mémoire (102) connectée au processeur (101), et un bus (103) ; dans lequel le processeur (101) et la mémoire (102) communiquent l'un avec l'autre par l'intermédiaire du bus, et le processeur (101) est configuré pour appeler une instruction de programme stockée dans la mémoire (102) pour réaliser le procédé de commande d'une vitesse de collision selon l'une quelconque des revendications 1 à 2 mis en œuvre par ordinateur.
